# EUROPEAN PATENT SPECIFICATION

(11) **EP 2 896 602 B1**
(45) Date of publication and mention of the grant of the patent: **09.08.2017**
(21) Application number: 14000155.3
(22) Date of filing: 16.01.2014
(51) Int. Cl.: C03C 8/04, C04B 35/01, C04B 35/453, C04B 35/634, H01B 1/22, H01L 31/0224, H01L 31/042, C03C 8/02, C03C 8/18

(54) **Low-silver electroconductive paste**
Silberarme, elektrisch leitende Paste
Pâte électroconductrice à faible teneur en argent

(43) Date of publication of application: 22.07.2015
(73) Proprietor: Heraeus Precious Metals North America Conshohocken LLC, West Conshohocken, PA 19428 (US)
(72) Inventor: Sun, Zhiqing, Shanghai (CN)
(74) Representative: Heraeus IP

(56) References cited:
- WO-A1-2013/023181
- CN-A- 103 000 251
- US-A- 5 346 651
- US-A- 5 378 408
- US-A1- 2013 139 873
- DZIEDZIC A ET AL: "THICK-FILM FINE-LINE FABRICATION TECHNIQUES - APPLICATION FRONT METALLISATION OF SOLAR CELLS", HYBRID CIRCUITS, CONZETT & HUBER, RUISLIP, MIDDLESEX, no. 30, 1 January 1993 (1993-01-01), pages 18-22,26, XP002057492, ISSN: 0265-3028

## Description

### FIELD OF THE INVENTION

This invention relates to electroconductive paste compositions utilized in solar panel technology, especially for forming backside soldering pads. Specifically, in one aspect, the invention is an electroconductive paste composition comprising conductive particles, an organic vehicle and glass frit. The conductive particles preferably include silver powder and silver flake, and the glass frit preferably has a particle size (d₉₀) of 0.01 to 3 microns. Another aspect of the invention is a solar cell produced by applying the electroconductive paste of the invention to the backside of a silicon wafer to form soldering pads. The invention also provides a solar panel comprising electrically interconnected solar cells. According to another aspect, the invention also provides a method of producing a solar cell.

### BACKGROUND OF THE INVENTION

Solar cells are devices that convert the energy of light into electricity using the photovoltaic effect. Solar power is an attractive green energy source because it is sustainable and produces only non-polluting by-products. Accordingly, a great deal of research is currently being devoted to developing solar cells with enhanced efficiency while continuously lowering material and manufacturing costs.

When light hits a solar cell, a fraction of the incident light is reflected by the surface and the remainder is transmitted into the solar cell. The photons of the transmitted light are absorbed by the solar cell, which is usually made of a semiconducting material such as silicon. The energy from the absorbed photons excites electrons of the semiconducting material from their atoms, generating electron-hole pairs. These electron-hole pairs are then separated by p-n junctions and collected by conductive electrodes applied on the solar cell surface.

The most common solar cells are those made of silicon. Specifically, a p-n junction is made from silicon by applying an n-type diffusion layer onto a p-type silicon substrate, coupled with two electrical contact layers or electrodes. In a p-type semiconductor, dopant atoms are added to the semiconductor in order to increase the number of free charge carriers (positive holes). Essentially, the doping material takes away weakly bound outer electrons from the semiconductor atoms. One example of a p-type semiconductor is silicon with a boron or aluminum dopant. Solar cells can also be made from n-type semiconductors. In an n-type semiconductor, the dopant atoms provide extra electrons to the host substrate, creating an excess of negative electron charge carriers. One example of an n-type semiconductor is silicon with a phosphorous dopant. In order to minimize reflection of the sunlight by the solar cell, an antireflective coating, such as silicon nitride, is applied to the n-type diffusion layer to increase the amount of light coupled into the solar cell.

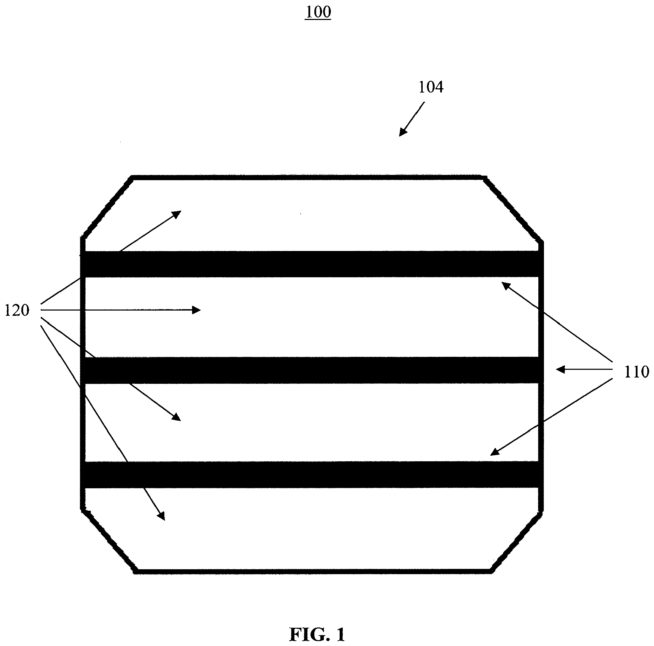

Solar cells typically have electroconductive pastes applied to both their front and back surfaces. The front side pastes result in the formation of electrodes that conduct the electricity generated from the exchange of electrons, as described above, while the backside pastes serve as solder joints for connecting solar cells in series via a solder coated conductive wire. To form a solar cell, a rear contact is first applied to the backside of the silicon wafer to form soldering pads, such as by screen printing a silver paste or silver/aluminum paste. Next, an aluminum backside paste is applied to the entire backside of the silicon wafer, slightly overlapping the soldering pads' edges, and the cell is then dried. Figure 1 shows a silicon solar cell 100 having soldering pads 110 running across the length of the cell, with an aluminum backside 120 printed over the entire surface. Lastly, using a different type of electroconductive paste, typically a silver-comprising paste, a metal contact may be screen printed onto the front side of the silicon wafer to serve as a front electrode. This electrical contact layer on the face or front of the cell, where light enters, is typically present in a grid pattern made of finger lines and bus bars, rather than a complete layer, because the metal grid materials are typically not transparent to light. The silicon substrate, with the printed front side and backside paste, is then fired at a temperature of approximately 700-975°C. During firing, the front side paste etches through the antireflection layer, forms electrical contact between the metal grid and the semiconductor, and converts the metal pastes to metal electrodes. On the backside, the aluminum diffuses into the silicon substrate, acting as a dopant which creates a back surface field (BSF). This field helps to improve the efficiency of the solar cell.

The resulting metallic electrodes allow electricity to flow to and from solar cells connected in a solar panel. To assemble a panel, multiple solar cells are connected in series and/or in parallel and the ends of the electrodes of the first cell and the last cell are preferably connected to output wiring. The solar cells are typically encapsulated in a transparent thermal plastic resin, such as silicon rubber or ethylene vinyl acetate. A transparent sheet of glass is placed on the front surface of the encapsulating transparent thermal plastic resin. A back protecting material, for example, a sheet of polyethylene terephthalate coated with a film of polyvinyl fluoride having good mechanical properties and good weather resistance, is placed under the encapsulating thermal plastic resin. These layered materials may be heated in an appropriate vacuum furnace to remove air, and then integrated into one body by heating and pressing. Furthermore, since solar modules are typically left in the open air for a long time, it is desirable to cover the circumference of the solar cell with a frame material consisting of aluminum or the like.

A typical electroconductive paste for backside use contains metallic particles, glass frit, and an organic vehicle. Electroconductive pastes are described in U.S. Patent Application No. 2013/139873, U.S. Patent Application No. 5378408, WO 2013/023181, U.S. Patent Application Publication No. 2013/0148261, Chinese Patent Publication No. 101887764, and Chinese Patent Publication No. 101604557. The paste components should be carefully selected to take full advantage of the theoretical potential of the resulting solar cell. The soldering pads formed by the backside paste, usually comprising silver or silver/aluminum, are particularly important, as soldering to an aluminum backside layer is practically impossible. The soldering pads may be formed as bars extending the length of the silicon substrate (as shown in Figure 1), or discrete segments arranged along the length of the silicone substrate. The soldering pads should adhere well to the silicon substrate, and should be able to withstand the mechanical manipulation of soldering a bonding wire, while having no detrimental effect on the efficiency of the solar cell.

A typical method used to test the adhesion of backside soldering pads is to apply a solder wire to the silver layer soldering pad and then measure the force required to peel off the soldering wire at a certain angle relative to the substrate, typically 180 degrees. Generally, a pull force of greater than 2 Newtons is the minimum requirement, with higher forces considered more desirable. Thus, compositions for electroconductive pastes with improved adhesive strength are desired.

### SUMMARY OF THE INVENTION

Accordingly, the invention provides electroconductive paste compositions exhibiting improved adhesive strength.

The invention provides an electroconductive paste composition for electrode formation in solar cells including about 20 to about 50 wt% spherical silver powder having a particle size d50 of about 0.1 µm to about 1 µm, based upon 100% total weight of the paste, about 10 to about 30 wt% silver flake having a particle size d50 of about 5-8 µm, based upon 100% total weight of the paste, substantially lead-free glass frit having a particle size d90 of about 0.5-3 µm, and organic vehicle, wherein the glass frit includes less than 5 wt% zinc oxide, based upon 100% total weight of the glass system.

The invention also provides a solar cell including a silicon wafer having a front side and a backside, and a soldering pad formed on the silicon wafer produced from an electroconductive paste according to the invention.

The invention further provides a solar cell module including electrically interconnected solar cells according to the invention.

The invention also provides a method of producing a solar cell, including the steps of providing a silicon wafer having a front side and a backside, applying an electroconductive paste composition according to the invention onto the backside of the silicon wafer, and firing the silicon wafer.

### BRIEF DESCRIPTION OF THE DRAWINGS

A more complete appreciation of the invention and many of the attendant advantages thereof will be readily obtained as the same becomes better understood by reference to the following detailed description when considered in connection with the following accompanying drawing, FIG. 1, which is a plan view of the backside of a silicon solar cell having printed silver soldering pads running across the length of the cell according to an exemplary embodiment of the invention.

### DETAILED DESCRIPTION

The invention relates to an electroconductive paste composition useful for application to the backside of a solar cell. The electroconductive paste composition preferably comprises metallic particles, glass frit, and an organic vehicle. While not limited to such an application, such pastes may be used to form an electrical contact layer or electrode in a solar cell, as well as to form soldering pads used to interconnect solar cells in a module.

Figure 1 illustrates exemplary soldering pads 110 deposited on the backside of a silicon solar cell 100. In this particular example, screen printed silver soldering pads 110 run across the length of the silicon solar cell 100. In other configurations, the soldering pads 110 may be of discrete segments. The soldering pads 110 can be of any shape and size such as those known in the art. A second backside paste, e.g., a paste comprising aluminum, is also printed on the backside of the silicon solar cell 100 and makes contact with the edges of the soldering pads 110. This second backside paste forms the BSF 120 of the solar cell 100 when fired.

### Electroconductive Paste

One aspect of the invention relates to the composition of an electroconductive paste used to form backside soldering pads. A desired backside paste is one which has high adhesive strength to allow for optimal solar cell mechanical reliability, while also optimizing the solar cell's electrical performance. The electroconductive paste composition according to the invention is generally comprised of metallic particles, organic vehicle, and glass frit. According to one embodiment, the backside electroconductive paste comprises about 30-75 wt% total metallic particles, about 0.01-10 wt% glass frit, and about 20-60 wt% organic vehicle, based upon 100% total weight of the paste.

### Glass Frit

The glass frit of the invention improves the adhesive strength of the resulting electroconductive paste. The metallic content of an electroconductive paste used to print backside soldering pads has an effect on the adhesive strength of the paste. Higher metallic particle content, for example between 60-75 wt%, based upon 100% total weight of the paste, provides better adhesion because there is more solderable material available. When the metallic content is lower than 60 wt%, the adhesive forces are drastically reduced. Thus, the glass frit becomes even more important because it compensates for the reduction in adhesive strength. In addition, certain pastes used to form soldering pads can interact with the aluminum paste which is applied over the entire backside surface of the silicon solar cell to form the BSF. When this happens, blisters or defects form at the region where the backside soldering paste and the surface aluminum paste overlap. The glass compositions of the invention mitigate this interaction between the soldering paste and the aluminum layer.

The electroconductive paste of the invention may comprise about 0.01-10 wt% glass frit, preferably about 0.01-7 wt%, more preferably about 0.01-6 wt% and even more preferably about 0.01-5 wt%, based upon 100% total weight of the paste. In a most preferred embodiment, the electroconductive paste comprises about 3 wt% glass frit.

It is well known in the art that glass frit particles can exhibit a variety of shapes and sizes. Some examples of the various shapes of glass frit particles include spherical, angular, elongated (rod or needle like), and flat (sheet like). Glass frit particles may also be present as a combination of particles of different shapes. Glass frit particles with a shape, or combination of shapes, which favor advantageous adhesion of the produced electrode are preferred according to the invention.

Particle diameter is a characteristic of particles well known to the person skilled in the art. Particle size d₅₀ is the median diameter or the medium value of the particle size distribution. It is the value of the particle diameter at 50% in the cumulative distribution. Particle size d₁₀ is the diameter at which approximately 10% of the particles in the cumulative distribution have a smaller diameter. Likewise, particle size d₉₀ is the diameter at which approximately 90% of the particles in the cumulative distribution have a smaller diameter.

Particle size distribution may be measured via laser diffraction, dynamic light scattering, imaging, electrophoretic light scattering, or any other method known in the art. A Horiba LA-910 Laser Diffraction Particle Size Analyzer connected to a computer with the LA-910 software program is used to determine the particle size distribution of the glass frit according to the invention. The relative refractive index of the glass frit particle is chosen from the LA-910 manual and entered into the software program. The test chamber is filled with deionized water to the proper fill line on the tank. The solution is then circulated by using the circulation and agitation functions in the software program. After one minute, the solution is drained. This is repeated an additional time to ensure the chamber is clean of any residual material. The chamber is then filled with deionized water for a third time and allowed to circulate and agitate for one minute. Any background particles in the solution are eliminated by using the blank function in the software. Ultrasonic agitation is then started, and the glass frit is slowly added to the solution in the test chamber until the transmittance bars are in the proper zone in the software program. Once the transmittance is at the correct level, the laser diffraction analysis is run and the particle size distribution of the glass frit is measured and given as particle size d₁₀, d₅₀, and/or d₉₀.

In a preferred embodiment of the invention, the median particle diameter d₅₀ of the glass frit lies in a range from about 0.01-3 µm, preferably in a range from about 0.01-2 µm, and most preferably in a range from about 0.1-1 µm. According to another embodiment, the particle diameter d₁₀ of the glass frit lies in a range of about 0.01-1 µm, preferably about 0.01-0.5 µm, and more preferably about 0.01-0.2 µm. According to yet another embodiment, the particle diameter d₉₀ of the glass frit lies in a range of about 0.5-3 µm, preferably 1-3 µm, and more preferably about 2-3 µm. It is believed that the inclusion of glass frits having particles size d₉₀ in a range of about 0.5 to about 3 µm improves the electrical performance of the resulting paste.

Another way to characterize the shape and surface of a particle is by its surface area to volume ratio (specific surface area). Methods of measuring specific surface area are known in the art. As set forth herein, all surface area measurements were performed using the BET (Brunauer-Emmett-Teller) method on a Horiba SA-9600 Specific Surface Area Analyzer. The metallic particle sample is loaded into the bottom cylinder of a U-tube until it is approximately one half full. The mass of sample loaded into the U-tube is then measured. This U-tube is mounted into the instrument and degassed for 15 minutes at 140°C using a 30% nitrogen/balance helium gas. Once the sample is degassed, it is mounted into the analysis station. Liquid nitrogen is then used to fill the sample dewar baths, and the surface adsorption and desportion curves are measured by the machine. Once the surface area is determined by the analyzer, the specific surface area is calculated by dividing this value by the mass of the metallic particle sample used to fill the U-tube.

In one embodiment, the glass frit particles have a specific surface area of about 0.5 m²/g to about 11 m²/g, preferably about 1 m²/g to about 10 m²/g, and most preferably about 2 m²/g to about 8 m²/g.

According to one embodiment, the glass frit includes Bi₂O₃, Al₂O₃, SiO₂, B₂O₃, SrO, or a combination thereof. In one embodiment, the glass frit includes Bi₂O₃, Al₂O₃, SiO₂, B₂O₃, and SrO. Such a combination has been determined to improve the resulting adhesive properties of the paste composition.

Further, according to one embodiment, the glass frit has less than 5 wt% zinc oxide (ZnO). According to a preferred embodiment, the glass frit is free or substantially free of zinc oxide. As used herein, the term "substantially free" generally refers to less than 1 wt% zinc oxide in the paste.

According to other embodiments of the invention, the glass frit present in the electroconductive paste may comprise other elements, oxides, compounds which generate oxides on heating, or mixtures thereof. Preferred elements in this context are silicon, boron, aluminum, bismuth, lithium, sodium, magnesium, gadolinium, cerium, zirconium, titanium, manganese, tin, ruthenium, cobalt, iron, copper, barium and chromium, or combinations thereof. According to one embodiment, the glass frit may comprise lead or may be substantially lead-free. Preferably, the glass frit is substantially lead-free. As used herein, the term "substantially lead-free" generally refers to less than about 0.5 wt% lead, based upon total weight of the glass frit.

Preferred oxides which can be incorporated into the glass frit may include alkali metal oxides, alkali earth metal oxides, rare earth oxides, group V and group VI oxides, other oxides, or combinations thereof. Preferred alkali metal oxides in this context are sodium oxide, lithium oxide, potassium oxide, rubidium oxides, cesium oxides or combinations thereof. Preferred alkali earth metal oxides in this context are beryllium oxide, magnesium oxide, calcium oxide, strontium oxide, barium oxide, or combinations thereof. Preferred group V oxides in this context are phosphorous oxides, such as P₂O₅, bismuth oxides, such as Bi₂O₃, or combinations thereof. Preferred group VI oxides in this context are tellurium oxides, such as TeO₂, or TeO₃, selenium oxides, such as SeO₂, or combinations thereof. Preferred rare earth oxides are cerium oxides, such as CeO₂ and lanthanum oxides, such as La₂O₃. Other preferred oxides in this context are silicon oxides (e.g., SiO₂), aluminum oxides (e.g., Al₂O₃), germanium oxides (e.g., GeO₂), vanadium oxides (e.g., V₂O₅), niobium oxides (e.g., Nb₂O₅), boron oxide (e.g., B₂O₃), tungsten oxides (e.g., WO₃), molybdenum oxide (e.g., MoO₃), indium oxides (e.g., In₂O₃), further oxides of those elements listed above as preferred elements, and combinations thereof. Mixed oxides containing at least two of the elements listed as preferred elemental constituents of the glass frit, or mixed oxides which are formed by heating at least one of the above named oxides with at least one of the above named metals may also be used. Mixtures of at least two of the above-listed oxides and mixed oxides may also be used in the context of the invention.

According to one embodiment of the invention, the glass frit has a glass transition temperature (Tg) below the desired firing temperature of the electroconductive paste. Preferred glass frits have a Tg of about 250 °C to about 750 °C, preferably in a range from about 300 °C to about 700 °C, and most preferably in a range from about 350 °C to about 650 °C, when measured using thermomechanical analysis. The glass transition temperature Tg can be determined using a DSC apparatus Netzsch STA 449 F3 Jupiter (commercially available from Netzsch) equipped with a sample holder HTP 40000A69.010, thermocouple Type S and a platinum oven Pt S TC:S (all commercially available from Netzsch). For measurements and data evaluation, the software Netzsch Messung V5.2.1 and Proteus Thermal Analysis V5.2.1 are used. As pan for reference and sample, aluminum oxide pan GB 399972 and cap GB 399973 (both commercially available from Netzsch) with a diameter of 6.8 mm and a volume of about 85 µl are used. An amount of about 20-30 mg of the sample is weighted into the sample pan with an accuracy of 0.01 mg. The empty reference pan and the sample pan are placed in the apparatus, the oven is closed and the measurement started. A heating rate of 10 K/min is employed from a starting temperature of 25°C to an end temperature of 1000 °C. The balance in the instrument is always purged with nitrogen (N₂ 5.0) and the oven is purged with synthetic air (80% N₂ and 20% O₂ from Linde) with a flow rate of 50 ml/min. The first step in the DSC signal is evaluated as glass transition using the software described above and the determined onset value is taken as the temperature for Tg.

The glass frit particles may be present with a surface coating. Any such coating known in the art and suitable in the context of the invention can be employed on the glass frit particles. Preferred coatings according to the invention are those coatings which promote improved adhesion characteristics of the electroconductive paste. If such a coating is present, it is preferred for that coating to correspond to about 0.01-10 wt%, preferably about 0.01-8 wt%, about 0.01-5 wt%, about 0.01-3 wt%, and most preferably about 0.01-1 wt%, in each case based on the total weight of the glass frit particles.

### Conductive Metallic Particles

The electroconductive backside paste of the invention also comprises conductive metallic particles. The electroconductive paste may comprise about 30 to about 75 wt% total metallic conductive particles, based upon 100% total weight of the paste. In another embodiment, the electroconductive paste may comprise about 40 to about 60 wt%, preferably about 50 to about 60 wt%, total metallic conductive particles. According to one embodiment, the electroconductive paste comprises about 52 wt% conductive metallic particles. While lower metallic particle content decreases the adhesion of the resulting paste, it also lowers the cost of manufacturing the resulting paste.

All metallic particles known in the art, and which are considered suitable in the context of the invention, may be employed as the metallic particles in the electroconductive paste. Preferred metallic particles in the context of the invention are those which exhibit conductivity and which yield soldering pads with high adhesion and low series and rear grid resistance. Preferred metallic particles according to the invention are elemental metals, alloys, metal derivatives, mixtures of at least two metals, mixtures of at least two alloys or mixtures of at least one metal with at least one alloy.

Preferred metals include at least one of silver, aluminum, gold and nickel, and alloys or mixtures thereof. In a preferred embodiment, the metallic particles comprise silver. Suitable silver derivatives include, for example, silver alloys and/or silver salts, such as silver halides (e.g., silver chloride), silver nitrate, silver acetate, silver trifluoroacetate, silver orthophosphate, and combinations thereof. In one embodiment, the metallic particles comprise a metal or alloy coated with one or more different metals or alloys, for example silver particles coated with aluminum.

The metallic particles can exhibit a variety of shapes, sizes, surface area to volume ratios, and coating layers. A variety of shapes are known in the art. Some examples include spherical, angular, elongated (rod or needle like) and flat (sheet like). Metallic particles may also be present as a combination of particles of different shapes. Metallic particles with a shape, or combination of shapes, which favor adhesion are preferred according to the invention. One way to characterize such shapes without considering the surface nature of the particles is through the following parameters: length, width and thickness. In the context of the invention, the length of a particle is given by the length of the longest spatial displacement vector, both endpoints of which are contained within the particle. The width of a particle is given by the length of the longest spatial displacement vector perpendicular to the length vector defined above both endpoints of which are contained within the particle. The thickness of a particle is given by the length of the longest spatial displacement vector perpendicular to both the length vector and the width vector, both defined above, both endpoints of which are contained within the particle.

In one embodiment, metallic particles with shapes as uniform as possible are used (i.e. shapes in which the ratios relating the length, the width and the thickness are as close as possible to 1, preferably all ratios lying in a range from about 0.7 to about 1.5, more preferably in a range from about 0.8 to about 1.3 and most preferably in a range from about 0.9 to about 1.2). Examples of preferred shapes for the metallic particles in this embodiment are spheres and cubes, or combinations thereof, or combinations of one or more thereof with other shapes.

In another embodiment, metallic particles which have a shape of low uniformity are used, with at least one of the ratios relating the dimensions of length, width and thickness being above about 1.5, more preferably above about 3 and most preferably above about 5. Preferred shapes according to this embodiment are flake shaped, rod or needle shaped, or a combination of flake shaped, rod or needle shaped with other shapes.

It is preferred according to the invention that a combination of silver powder and silver flake is used. The paste preferable comprises about 30 to about 75 wt% total silver (powder and flake), preferably about 40 to about 60 wt% total silver, and most preferably about 50 to about 60 wt% total silver, based upon 100% total weight of the paste. A combination of silver powder and silver flake balances the adhesive properties and solderability of the resulting paste. A paste which is rich in silver powder is denser, and thus has improved adhesion, but also deteriorates the solderability of the paste. Thus, silver flake is also incorporated into the paste to improve its solderability. Preferably, the silver powder is spherical. For example, the ratio of length, width, and thickness of the silver powder may be 0.5-10 : 0.5-10 : 0.05-2. The electroconductive paste preferably comprises about 20 to about 50 wt% silver powder, preferably about 20 to about 40 wt% silver powder, and more preferably about 30 to about 40 wt% silver powder, based upon 100% total weight of the paste. According to a most preferred embodiment, the electroconductive paste comprises about 35 wt% silver powder. Further, the electroconductive paste preferably comprises about 10 to about 30 wt% silver flake, more preferably about 10 to about 20 wt% silver flake, based upon 100% total weight of the paste. According to a most preferred embodiment, the electroconductive paste comprises about 17 wt% silver flake. The thickness of the silver flake may be about 0.5 - 1 µm. The combination of silver powder and silver flake, in the preferred amounts, is believed to improve the overall adhesive performance and solderability of the resulting paste.

With respect to the silver powder, it is preferred that the median particle diameter d₅₀, as set forth herein, lie in a range from about 0.1 to about 3 µm, preferably in a range from about 0.1 to about 1.5 µm, and more preferably in a range from about 0.1 µm to about 1 µm. In a most preferred embodiment, the silver powder has a median particle diameter d₅₀ of about 0.5 µm. With respect to the silver flake, it is preferred that the median particle diameter d₅₀, as set forth herein, lie in a range from about 5-8 µm, preferably in a range from about 7-8 µm.

In one embodiment, the silver powder may have a specific surface area of about 1-10 m²/g, and preferably about 5-8 m²/g. The silver flake may have a specific surface area of about 0.1-3 m²/g, and preferably about 0.8-1.4 m²/g.

As additional constituents of the metallic particles, further to the above-mentioned constituents, those constituents which contribute to more favorable contact properties, adhesion, and electrical conductivity are preferred according to the invention. For example, the metallic particles may be present with a surface coating. Any such coating known in the art, and which is considered to be suitable in the context of the invention, may be employed on the metallic particles. Preferred coatings according to the invention are those coatings which promote the adhesion characteristics of the resulting electroconductive paste. If such a coating is present, it is preferred according to the invention for that coating to correspond to about 0.01-10 wt%, preferably about 0.01-8 wt%, most preferably about 0.01-5 wt%, based on 100% total weight of the metallic particles.

### Organic Vehicle

Preferred organic vehicles in the context of the invention are solutions, emulsions or dispersions based on one or more solvents, preferably an organic solvent, which ensure that the constituents of the electroconductive paste are present in a dissolved, emulsified or dispersed form. Preferred organic vehicles are those which provide optimal stability of constituents within the electroconductive paste and endow the electroconductive paste with a viscosity allowing for effective printability. In one embodiment, the organic vehicle is present in an amount of about 20-60 wt%, more preferably about 30-50 wt%, and most preferably about 40-50 wt%, based upon 100% total weight of the paste.

In one embodiment, the organic vehicle comprises an organic solvent and one or more of a binder (e.g., a polymer), a surfactant and a thixotropic agent, or any combination thereof. For example, in one embodiment, the organic vehicle comprises one or more binders in an organic solvent.

The binder may be present in an amount between about 0.1 and 10 wt%, preferably between about 0.1-8 wt%, more preferably between about 0.5-7 wt%, based upon 100% total weight of the organic vehicle. Preferred binders in the context of the invention are those which contribute to the formation of an electroconductive paste with favorable stability, printability, viscosity and sintering properties. All binders which are known in the art, and which are considered to be suitable in the context of this invention, can be employed as the binder in the organic vehicle. Preferred binders according to the invention (which often fall within the category termed "resins") are polymeric binders, monomeric binders, and binders which are a combination of polymers and monomers. Polymeric binders can also be copolymers, wherein at least two different monomeric units are contained in a single molecule. Preferred polymeric binders include those which carry functional groups in the polymer main chain, those which carry functional groups off of the main chain, and those which carry functional groups both within the main chain and off of the main chain. Preferred polymers carrying functional groups in the main chain include, for example, polyesters, substituted polyesters, polycarbonates, substituted polycarbonates, polymers which carry cyclic groups in the main chain, poly-sugars, substituted poly-sugars, polyurethanes, substituted polyurethanes, polyamides, substituted polyamides, phenolic resins, substituted phenolic resins, copolymers of the monomers of one or more of the preceding polymers, optionally with other co-monomers, or a combination of at least two thereof. According to one embodiment, the binder may be polyvinyl butyral or polyethylene. Preferred polymers which carry cyclic groups in the main chain include, for example, polyvinylbutylate (PVB) and its derivatives and poly-terpineol and its derivatives or mixtures thereof. Preferred poly-sugars include, for example, ethyl cellulose, cellulose and alkyl derivatives thereof, methyl cellulose, hydroxyethyl cellulose, propyl cellulose, hydroxypropyl cellulose, butyl cellulose, their derivatives and mixtures of at least two thereof. Other preferred polymers include, for example, cellulose ester resins, e.g., cellulose acetate propionate, cellulose acetate buyrate, and any combinations thereof. Other preferred polymers are cellulose ester resins, such as, for example, cellulose acetate propionate, cellulose acetate butyrate, and mixtures thereof, preferably those disclosed in U.S. Patent Application Publication No. 2013/0180583. Preferred polymers which carry functional groups off of the main polymer chain are those which carry amide groups, those which carry acid and/or ester groups, often called acrylic resins, or polymers which carry a combination of aforementioned functional groups, or a combination thereof. Preferred polymers which carry amide off of the main chain include, for example, polyvinyl pyrrolidone (PVP) and its derivatives. Preferred polymers which carry acid and/or ester groups off of the main chain include, for example, polyacrylic acid and its derivatives, polymethacrylate (PMA) and its derivatives, polymethylmethacrylate (PMMA) and its derivatives, or a mixture thereof. Preferred monomeric binders according to the invention include, for example, ethylene glycol based monomers, terpineol resins or rosin derivatives, or a mixture thereof. Preferred monomeric binders based on ethylene glycol are those with ether groups, ester groups or those with an ether group and an ester group, preferred ether groups being methyl, ethyl, propyl, butyl, pentyl hexyl and higher alkyl ethers, the preferred ester group being acetate and its alkyl derivatives, preferably ethylene glycol monobutylether monoacetate or a mixture thereof. Alkyl cellulose, preferably ethyl cellulose, its derivatives and mixtures thereof with other binders from the preceding lists of binders or otherwise are the most preferred binders in the context of the invention.

The organic solvent may be present in an amount between about 40 and 90 wt%, more preferably between about 35 and 85 wt%, based upon 100% total weight of the organic vehicle. When measured based upon 100% total weight of the paste, the organic solvent may be present in an amount of about 0.01-5 wt%, preferably about 0.01-3 wt%, more preferably about 0.01-2 wt%. In a preferred embodiment, the electroconductive paste comprises about 1 wt% organic solvent, based upon 100% total weight of the paste.

Preferred solvents according to the invention are constituents of the electroconductive paste which are removed from the paste to a significant extent during firing, preferably those which are present after firing with an absolute weight reduced by at least about 80% compared to before firing, preferably reduced by at least about 95% compared to before firing. Preferred solvents according to the invention are those which allow an electroconductive paste to be formed which has favorable viscosity, printability, stability and sintering characteristics. All solvents which are known in the art, and which are considered to be suitable in the context of this invention, may be employed as the solvent in the organic vehicle. According to the invention, preferred solvents are those which allow the preferred high level of printability of the electroconductive paste as described above to be achieved. Preferred solvents according to the invention are those which exist as a liquid under standard ambient temperature and pressure (SATP) (298.15 K, 25 °C, 77 °F), 100 kPa (14.504 psi, 0.986 atm), preferably those with a boiling point above about 90 °C and a melting point above about -20 °C. Preferred solvents according to the invention are polar or non-polar, protic or aprotic, aromatic or non-aromatic. Preferred solvents according to the invention include, for example, mono-alcohols, di-alcohols, poly-alcohols, mono-esters, di-esters, poly-esters, mono-ethers, di-ethers, poly-ethers, solvents which comprise at least one or more of these categories of functional group, optionally comprising other categories of functional group, preferably cyclic groups, aromatic groups, unsaturated bonds, alcohol groups with one or more O atoms replaced by heteroatoms, ether groups with one or more O atoms replaced by heteroatoms, esters groups with one or more O atoms replaced by heteroatoms, and mixtures of two or more of the aforementioned solvents. Preferred esters in this context include, for example, di-alkyl esters of adipic acid, preferred alkyl constituents being methyl, ethyl, propyl, butyl, pentyl, hexyl and higher alkyl groups or combinations of two different such alkyl groups, preferably dimethyladipate, and mixtures of two or more adipate esters. Preferred ethers in this context include, for example, diethers, preferably dialkyl ethers of ethylene glycol, preferred alkyl constituents being methyl, ethyl, propyl, butyl, pentyl, hexyl and higher alkyl groups or combinations of two different such alkyl groups, and mixtures of two diethers. Preferred alcohols in this context include, for example, primary, secondary and tertiary alcohols, preferably tertiary alcohols, terpineol and its derivatives, or a mixture of two or more alcohols. Preferred solvents which combine more than one different functional groups include, for example, 2,2,4-trimethyl-1,3-pentanediol monoisobutyrate ("texanol") and its derivatives, 2-(2-ethoxyethoxy)ethanol ("carbitol") and its alkyl derivatives, preferably methyl, ethyl, propyl, butyl, pentyl, and hexyl carbitol, preferably hexyl carbitol or butyl carbitol, and acetate derivatives thereof, preferably butyl carbitol acetate, or mixtures of at least two of the aforementioned.

The organic vehicle may also comprise a surfactant and/or additives. If present, the electroconductive paste may comprise about 0-10 wt%, preferably about 0-8 wt%, and more preferably about 0.01-6 wt%, surfactant based upon 100% total weight of the organic vehicle. Preferred surfactants in the context of the invention are those which contribute to the formation of an electroconductive paste with favorable stability, printability, viscosity and sintering properties. All surfactants which are known in the art, and which are considered to be suitable in the context of this invention, may be employed as the surfactant in the organic vehicle. Preferred surfactants in the context of the invention are those based on linear chains, branched chains, aromatic chains, fluorinated chains, siloxane chains, polyether chains and combinations thereof. Preferred surfactants are single chained, double chained or poly chained. Preferred surfactants according to the invention may have non-ionic, anionic, cationic, amphiphilic, or zwitterionic heads. Preferred surfactants are polymeric and monomeric or a mixture thereof. Preferred surfactants according to the invention can have pigment affinic groups, preferably hydroxyfunctional carboxylic acid esters with pigment affinic groups (e.g., DISPERBYK®-108, manufactured by BYK USA, Inc.), acrylate copolymers with pigment affinic groups (e.g., DISPERBYK®-116, manufactured by BYK USA, Inc.), modified polyethers with pigment affinic groups (e.g., TEGO® DISPERS 655, manufactured by Evonik Tego Chemie GmbH), and other surfactants with groups of high pigment affinity (e.g., TEGO® DISPERS 662 C, manufactured by Evonik Tego Chemie GmbH). Other preferred polymers according to the invention not in the above list include, for example, polyethylene oxide, polyethylene glycol and its derivatives, and alkyl carboxylic acids and their derivatives or salts, or mixtures thereof. The preferred polyethylene glycol derivative according to the invention is poly(ethyleneglycol)acetic acid. Preferred alkyl carboxylic acids are those with fully saturated and those with singly or poly unsaturated alkyl chains or mixtures thereof. Preferred carboxylic acids with saturated alkyl chains are those with alkyl chains lengths in a range from about 8 to about 20 carbon atoms, preferably C₉H₁₉COOH (capric acid), C₁₁H₂₃COOH (Lauric acid), C₁₃H₂₇COOH (myristic acid) C₁₅H₃₁COOH (palmitic acid), C₁₇H₃₅COOH (stearic acid), or salts or mixtures thereof. Preferred carboxylic acids with unsaturated alkyl chains are C₁₈H₃₄O₂ (oleic acid) and C₁₈H₃₂O₂ (linoleic acid). The preferred monomeric surfactant according to the invention is benzotriazole and its derivatives.

Preferred additives in the organic vehicle are those additives which are distinct from the aforementioned vehicle components and which contribute to favorable properties of the electroconductive paste, such as advantageous viscosity and adhesion to the underlying substrate. Additives known in the art, and which are considered to be suitable in the context of the invention, may be employed as an additive in the organic vehicle. Preferred additives according to the invention are thixotropic agents, viscosity regulators, stabilizing agents, inorganic additives, thickeners, emulsifiers, dispersants or pH regulators, and any combinations thereof. Preferred thixotropic agents in this context are carboxylic acid derivatives, preferably fatty acid derivatives or combinations thereof. Preferred fatty acid derivatives are C₉H₁₉COOH (capric acid), C₁₁H₂₃COOH (Lauric acid), C₁₃H₂₇COOH (myristic acid) C₁₅H₃₁COOH (palmitic acid), C₁₇H₃₅COOH (stearic acid) C₁₈H₃₄O₂ (oleic acid), C₁₈H₃₂O₂ (linoleic acid) or combinations thereof. A preferred combination comprising fatty acids in this context is castor oil.

### Additives

Preferred additives in the context of the invention are constituents added to the electroconductive paste, in addition to the other constituents explicitly mentioned, which contribute to increased performance of the electroconductive paste, of the soldering pads produced thereof, or of the resulting solar cell. All additives known in the art, and which are considered suitable in the context of the invention, may be employed as additives in the electroconductive paste. In addition to additives present in the glass frit and in the vehicle, additives can also be present in the electroconductive paste. Preferred additives according to the invention are thixotropic agents, viscosity regulators, emulsifiers, stabilizing agents or pH regulators, inorganic additives, thickeners and dispersants, or a combination of at least two thereof, whereas inorganic additives are most preferred. Preferred inorganic additives in this context according to the invention are Mg, Ni, Te, W, Zn, Mg, Gd, Ce, Zr, Ti, Mn, Sn, Ru, Co, Fe, Cu and Cr or a combination of at least two thereof, preferably Zn, Sb, Mn, Ni, W, Te and Ru, or a combination of at least two thereof, oxides thereof, compounds which can generate those metal oxides on firing, or a mixture of at least two of the aforementioned metals, a mixture of at least two of the aforementioned oxides, a mixture of at least two of the aforementioned compounds which can generate those metal oxides on firing, or mixtures of two or more of any of the above mentioned.

According to one embodiment, the electroconductive paste composition, in addition to the glass frit, metallic particles, and organic vehicle, further comprises metal or metal oxides formed from copper, aluminum, bismuth, lithium, and tellurium. In a preferred embodiment, bismuth oxide (e.g., Bi₂O₃) is added to improve the overall adhesive properties of the electroconductive paste. Such additives may be present in an amount of about 0.01-2 wt%, based upon 100% total weight of the paste. In a preferred embodiment, the electroconductive paste comprises about 1 wt% Bi₂O₃.

### Forming the Electroconductive Paste Composition

To form the electroconductive paste composition, the glass frit materials may be combined with the metallic particles and the organic vehicle using any method known in the art for preparing a paste composition. The method of preparation is not critical, as long as it results in a homogenously dispersed paste. The components can be mixed, such as with a mixer, then passed through a three roll mill, for example, to make a dispersed uniform paste.

### Solar Cells

In another aspect, the invention relates to a solar cell. In one embodiment, the solar cell comprises a semiconductor substrate (e.g., a silicon wafer) and an electroconductive paste composition according to any of the embodiments described herein.

In another aspect, the invention relates to a solar cell prepared by a process comprising applying an electroconductive paste composition according to any of the embodiments described herein to a semiconductor substrate (such as a silicon wafer) and firing the semiconductor substrate.

### Silicon Wafer

Preferred wafers according to the invention have regions, among other regions of the solar cell, capable of absorbing light with high efficiency to yield electron-hole pairs and separating holes and electrons across a boundary with high efficiency, preferably across a p-n junction boundary. Preferred wafers according to the invention are those comprising a single body made up of a front doped layer and a back doped layer.

Preferably, the wafer comprises appropriately doped tetravalent elements, binary compounds, tertiary compounds or alloys. Preferred tetravalent elements in this context are Silicon, Ge or Sn, preferably Silicon. Preferred binary compounds are combinations of two or more tetravalent elements, binary compounds of a group III element with a group V element, binary com-pounds of a group II element with a group VI element or binary compounds of a group IV element with a group VI element. Preferred combinations of tetravalent elements are combinations of two or more elements selected from Silicon, Ge, Sn or C, preferably SiC. The preferred binary compounds of a group III element with a group V element is GaAs. According to a preferred embodiment of the invention, the wafer is silicon. The foregoing description, in which silicon is explicitly mentioned, also applies to other wafer compositions described herein.

The p-n junction boundary is located where the front doped layer and back doped layer of the wafer meet. In an n-type solar cell, the back doped layer is doped with an electron donating n-type dopant and the front doped layer is doped with an electron accepting or hole donating p-type dopant. In a p-type solar cell, the back doped layer is doped with p-type dopant and the front doped layer is doped with n-type dopant. According to a preferred embodiment of the invention, a wafer with a p-n junction boundary is prepared by first providing a doped silicon substrate and then applying a doped layer of the opposite type to one face of that substrate.

Doped silicon substrates are well known in the art. The doped silicon substrate can be prepared by any method known in the art and considered suitable for the invention. Preferred sources of silicon substrates according to the invention are mono-crystalline silicon, multi-crystalline silicon, amorphous silicon and upgraded metallurgical silicon, most preferably mono-crystalline silicon or multi-crystalline silicon. Doping to form the doped silicon substrate can be carried out simultaneously by adding the dopant during the preparation of the silicon substrate, or it can be carried out in a subsequent step. Doping subsequent to the preparation of the silicon substrate can be carried out by gas diffusion epitaxy, for example. Doped silicon substrates are also readily commercially available. According to one embodiment, the initial doping of the silicon substrate may be carried out simultaneously to its formation by adding dopant to the silicon mix. According to another embodiment, the application of the front doped layer and the highly doped back layer, if present, may be carried out by gas-phase epitaxy. This gas phase epitaxy is preferably carried out within a temperature range of about 500 °C to about 900 °C, more preferably from about 600 °C to about 800 °C, and most preferably from about 650 °C to about 750 °C, at a pressure in a range from about 2 kPa to about 100 kPa, preferably from about 10 to about 80 kPa, most preferably from about 30 to about 70 kPa.

It is known in the art that silicon substrates can exhibit a number of shapes, surface textures and sizes. The shape of the substrate may include cuboid, disc, wafer and irregular polyhedron, to name a few. According to a preferred embodiment of the invention, the wafer is a cuboid with two dimensions which are similar, preferably equal, and a third dimension which is significantly smaller than the other two dimensions. The third dimension may be at least 100 times smaller than the first two dimensions.

Further, a variety of surface types are known in the art. According to the invention, silicon substrates with rough surfaces are preferred. One way to assess the roughness of the substrate is to evaluate the surface roughness parameter for a sub-surface of the substrate, which is small in comparison to the total surface area of the substrate, preferably less than about one hundredth of the total surface area, and which is essentially planar. The value of the surface roughness parameter is given by the ratio of the area of the sub-surface to the area of a theoretical surface formed by projecting that sub-surface onto the flat plane best fitted to the sub-surface by minimizing mean square displacement. A higher value of the surface roughness parameter indicates a rougher, more irregular surface and a lower value of the surface roughness parameter indicates a smoother, more even surface. According to the invention, the surface roughness of the silicon substrate is preferably modified so as to produce an optimum balance between a number of factors including, but not limited to, light absorption and adhesion to the surface.

The two larger dimensions of the silicon substrate can be varied to suit the application required of the resultant solar cell. It is preferred according to the invention for the thickness of the silicon wafer to be about 0.01-0.5 mm, more preferably about 0.01-0.3 mm, and most preferably about 0.01-0.2 mm. Some wafers have a minimum thickness of 0.01 mm.

It is preferred according to the invention that the front doped layer be thin in comparison to the back doped layer. It is also preferred that the front doped layer have a thickness lying in a range from about 0.1 to about 10 µm, preferably in a range from about 0.1 to about 5 µm and most preferably in a range from about 0.1 to about 2 µm.

A highly doped layer can be applied to the back face of the silicon substrate between the back doped layer and any further layers. Such a highly doped layer is of the same doping type as the back doped layer and such a layer is commonly denoted with a + (n+-type layers are applied to n-type back doped layers and p+-type layers are applied to p-type back doped layers). This highly doped back layer serves to assist metallization and improve electroconductive properties. It is preferred according to the invention for the highly doped back layer, if present, to have a thickness in a range from about 1 to about 100 µm, preferably in a range from about 1 to about 50 µm and most preferably in a range from about 1 to about 15 µm.

### Dopants

Preferred dopants are those which, when added to the silicon wafer, form a p-n junction boundary by introducing electrons or holes into the band structure. It is preferred according to the invention that the identity and concentration of these dopants is specifically selected so as to tune the band structure profile of the p-n junction and set the light absorption and conductivity profiles as required. Preferred p-type dopants according to the invention are those which add holes to the silicon wafer band structure. All dopants known in the art and which are considered suitable in the context of the invention can be employed as p-type dopants. Preferred p-type dopants according to the invention are trivalent elements, particularly those of group 13 of the periodic table. Preferred group 13 elements of the periodic table in this context include, but are not limited to, B, Al, Ga, In, Tl, or a combination of at least two thereof, wherein B is particularly preferred.

Preferred n-type dopants according to the invention are those which add electrons to the silicon wafer band structure. All dopants known in the art and which are considered to be suitable in the context of the invention can be employed as n-type dopants. Preferred n-type dopants according to the invention are elements of group 15 of the periodic table. Preferred group 15 elements of the periodic table in this context include N, P, As, Sb, Bi or a combination of at least two thereof, wherein P is particularly preferred.

As described above, the various doping levels of the p-n junction can be varied so as to tune the desired properties of the resulting solar cell.

According to certain embodiments, the semiconductor substrate (i.e., silicon wafer) exhibits a sheet resistance above about 60 Ω/□, such as above about 65 Ω/□, 70 Ω/□, 90 Ω/□ or 95 Ω/□.

### Solar Cell Structure

A contribution to achieving at least one of the above described objects is made by a solar cell obtainable from a process according to the invention. Preferred solar cells according to the invention are those which have a high efficiency, in terms of proportion of total energy of incident light converted into electrical energy output. Solar cells which are lightweight and durable are also preferred. At a minimum, a solar cell includes: (i) front electrodes, (ii) a front doped layer, (iii) a p-n junction boundary, (iv) a back doped layer, and (v) soldering pads. The solar cell may also include additional layers for chemical/mechanical protection.

### Antireflective Layer

According to the invention, an antireflective layer may be applied as the outer layer before the electrode is applied to the front face of the solar cell. Preferred antireflective layers according to the invention are those which decrease the proportion of incident light reflected by the front face and increase the proportion of incident light crossing the front face to be absorbed by the wafer. Antireflective layers which give rise to a favorable absorption/reflection ratio, are susceptible to etching by the electroconductive paste, are otherwise resistant to the temperatures required for firing of the electroconductive paste, and do not contribute to increased recombination of electrons and holes in the vicinity of the electrode interface are preferred. All antireflective layers known in the art and which are considered to be suitable in the context of the invention can be employed. Preferred antireflective layers according to the invention are SiNₓ, SiO₂, Al₂O₃, TiO₂ or mixtures of at least two thereof and/or combinations of at least two layers thereof. According to a preferred embodiment, the antireflective layer is SiₓN_{y}, in particular where a silicon wafer is employed, wherein x is about 2-4 and y is about 3-5.

The thickness of antireflective layers is suited to the wavelength of the appropriate light. According to a preferred embodiment of the invention, the antireflective layers have a thickness in a range from about 20 to about 300 nm, more preferably in a range from about 40 to about 200 nm, and most preferably in a range from about 60 to about 110 nm.

### Passivation Layers

According to the invention, one or more passivation layers may be applied to the front and/or back side of the silicon wafer as an outer layer. The passivation layer(s) may be applied before the front electrode is formed, or before the antireflective layer is applied (if one is present). Preferred passivation layers are those which reduce the rate of electron/hole recombination in the vicinity of the electrode interface. Any passivation layer which is known in the art and which is considered to be suitable in the context of the invention can be employed. Preferred passivation layers according to the invention are silicon nitride, silicon dioxide and titanium dioxide. According to a most preferred embodiment, silicon nitride is used. It is preferred for the passivation layer to have a thickness in a range from about 0.1 nm to about 2 µm, more preferably in a range from about 1 nm to about 1 µm, and most preferably in a range from about 1 nm to about 200 nm.

### Additional Protective Layers

In addition to the layers described above which directly contribute to the principle function of the solar cell, further layers can be added for mechanical and chemical protection.

The cell can be encapsulated to provide chemical protection. Encapsulations are well known in the art and any encapsulation suitable for the invention can be employed. According to a preferred embodiment, transparent polymers, often referred to as transparent thermoplastic resins, are used as the encapsulation material, if such an encapsulation is present. Preferred transparent polymers in this context are silicon rubber and polyethylene vinyl acetate (PVA).

A transparent glass sheet may also be added to the front of the solar cell to provide mechanical protection to the front face of the cell. Transparent glass sheets are well known in the art and any transparent glass sheet suitable in the context of the invention may be employed.

A back protecting material may be added to the back face of the solar cell to provide mechanical protection. Back protecting materials are well known in the art and any back protecting material considered suitable in the context of the invention may be employed. Preferred back protecting materials according to the invention are those having good mechanical properties and weather resistance. The preferred back protection material according to the invention is polyethylene terephthalate with a layer of polyvinyl fluoride. It is preferred according to the invention for the back protecting material to be present underneath the encapsulation layer (in the event that both a back protection layer and encapsulation are present).

A frame material can be added to the outside of the solar cell to give mechanical support. Frame materials are well known in the art and any frame material considered suitable in the context of the invention may be employed. The preferred frame material according to the invention is aluminum.

### Method of Preparing Solar Cell

A solar cell may be prepared by applying an electroconductive paste composition to an antireflective coating, such as silicon nitride, silicon oxide, titanium oxide or aluminum oxide, on the front side of a semiconductor substrate, such as a silicon wafer. The backside electroconductive paste of the invention is then applied to the backside of the solar cell to form soldering pads. The electroconductive pastes may be applied in any manner known in the art and considered suitable in the context of the invention. Examples include, but are not limited to, impregnation, dipping, pouring, dripping on, injection, spraying, knife coating, curtain coating, brushing or printing or a combination of at least two thereof. Preferred printing techniques are ink-jet printing, screen printing, tampon printing, offset printing, relief printing or stencil printing or a combination of at least two thereof. It is preferred according to the invention that the electroconductive paste is applied by printing, preferably by screen printing. An aluminum paste is then applied to the backside of the substrate, overlapping the edges of the soldering pads formed from the backside electroconductive paste, to form the BSF. The substrate is then fired according to an appropriate profile.

Firing is necessary to sinter the printed soldering pads so as to form solid conductive bodies. Firing is well known in the art and can be effected in any manner considered suitable in the context of the invention. It is preferred that firing be carried out above the Tg of the glass frit materials.

According to the invention, the maximum temperature set for firing is below about 900 °C, preferably below about 860 °C. Firing temperatures as low as about 820 °C have been employed for obtaining solar cells. The firing temperature profile is typically set so as to enable the burnout of organic binder materials from the electroconductive paste composition, as well as any other organic materials present. The firing step is typically carried out in air or in an oxygen-containing atmosphere in a belt furnace. It is preferred according to the invention for firing to be carried out in a fast firing process with a total firing time in the range from about 30 s to about 3 minutes, more preferably in the range from about 30 s to about 2 minutes, and most preferably in the range from about 40 seconds to about 1 minute. The time above 600 °C is most preferably in a range from about 3 to 7 seconds. The substrate may reach a peak temperature in the range of about 700 to 900° C for a period of about 1 to 5 seconds. The firing may also be conducted at high transport rates, for example, about 100-500 cm/min, with resulting hold-up times of about 0.05 to 5 minutes. Multiple temperature zones, for example 3-12 zones, can be used to control the desired thermal profile.

Firing of electroconductive pastes on the front and back faces can be carried out simultaneously or sequentially. Simultaneous firing is appropriate if the electroconductive pastes applied to both faces have similar, preferably identical, optimum firing conditions. Where appropriate, it is preferred according to the invention for firing to be carried out simultaneously. Where firing is carried out sequentially, it is preferable according to the invention for the back electroconductive paste to be applied and fired first, followed by application and firing of the electroconductive paste to the front face.

### Measuring Adhesive Performance

One method used to measure the adhesive strength, also known as the pull force, of the resulting electroconductive paste is to apply a solder wire to the electroconductive paste layer (soldering pad) which has been printed on the backside of a silicon solar cell. A standard soldering wire is applied to the soldering pad either by an automated machine, such as Somont Cell Connecting automatic soldering machine (manufactured by Meyer Burger Technology Ltd.), or manually with a hand held solder gun according to methods known in the art. In the invention, a 0.20 x 0.20 mm copper ribbon with approximately 20 µm 62/36/2 solder coating was used, although other methods common in the industry and known in the art may be used. Specifically, a length of ribbon approximately 2.5 times the length of the solar cell is cut. A solder flux is coated onto the cut ribbon and allowed to dry for 1-5 minutes. The cell is then mounted into the soldering fixture and the ribbon is aligned on top of the cell busbar. The soldering fixture is loaded onto the preheat stage and the cell is preheated for 15 seconds at 150-180°C. After preheat, the soldering pins are lowered and the ribbon is soldered onto the busbar for 0.8-1.8 seconds at 220-250°C. With the copper wire soldered to the length of the soldering pad, the adhesion force is measured using a pull-tester such as GP Solar GP PULL-TEST Advanced. A tailing end of the soldered ribbon is attached to the force gauge on the pull-tester and peeled back at approximately 180° at a constant speed of 6 mm/s. The force gauge records the adhesive force in Newtons at a sampling rate of 100 s⁻¹.

When evaluating exemplary pastes, this solder and pull process is typically completed four times on four separate backside soldering pads to minimize variation in the data that normally results from the soldering process. One individual measurement from one experiment is not highly reliable, as discrete variations in the soldering process can affect the results. Therefore, an overall average from four pulls is obtained and the averaged pull forces are compared between pastes. A minimum of 1 Newton pull force is desirable. The acceptable industry standard for adhesive strength is typically above 2 Newtons. Stronger adhesion with a pull force of at least 3 Newtons, or in some instances, greater than 4 Newtons is most desirable. According to the invention, a pull force of at least 2.1 Newtons, preferably at least 3 Newtons, and most preferably at least 4 Newtons is preferred.

### Solar Cell Module

A contribution to achieving at least one of the above mentioned objects is made by a module having at least one solar cell obtained as described above. A plurality of solar cells according to the invention can be arranged spatially and electrically interconnected to form a collective arrangement called a module. Preferred modules according to the invention can have a number of arrangements, preferably a rectangular arrangement known as a solar panel. A large variety of ways to electrically connect solar cells, as well as a large variety of ways to mechanically arrange and fix such cells to form collective arrangements, are well known in the art. Any such methods known by one skilled in the art, and which are considered suitable in the context of the invention, may be employed. Preferred methods according to the invention are those which result in a low mass to power output ratio, low volume to power output ration, and high durability. Aluminum is the preferred material for mechanical fixing of solar cells according to the invention.

### FURTHER EMBODIMENTS

I. An electroconductive paste composition for electrode formation in solar cells comprising:
   about 20 to about 50 wt% spherical silver powder having a particle size d₅₀ of about 0.1 µm to about 1 µm, based upon 100% total weight of the paste;
   about 10 to about 30 wt% silver flake having a particle size d₅₀ of about 5-8 µm, based upon 100% total weight of the paste;
   substantially lead-free glass frit having a particle size d₉₀ of about 0.5 - 3 µm; and
   organic vehicle,
   wherein the glass frit includes less than 5 wt% zinc oxide, based upon 100% total weight of the glass system.
II. The electroconductive paste composition according to embodiment I, wherein the electroconductive paste composition comprises about 20 to about 40 wt% spherical silver powder, preferably about 30 to about 40 wt% spherical silver powder, based upon 100% total weight of the electroconductive paste composition.
III. The electroconductive paste composition according to embodiments II or III wherein the electroconductive paste composition comprises about 10 to about 20 wt% silver flake, based upon 100% total weight of the electroconductive paste composition.
IV. The electroconductive paste composition according to any of the preceding embodiments, wherein the electroconductive paste composition comprises about 30 to about 75 wt% total silver, preferably about 40 to about 60 wt% total silver, and most preferably about 50 to about 60 wt% total silver, based upon 100% total weight of the paste, wherein the total silver includes the spherical silver powder and the silver flake.
V. The electroconductive paste composition according to any one of the preceding embodiments, wherein the spherical silver powder has a particle size d₅₀ of about 0.5 µm.
VI. The electroconductive paste composition according to any one of the preceding embodiments, wherein the glass frit is about 0.01-10 wt% of the paste, preferably about 0.01-7 wt%, more preferably about 0.01-6 wt%, and most preferably about 0.01-5 wt%, based upon 100% total weight of the paste.
VII. The electroconductive paste composition according to any one of the preceding embodiments, wherein the glass frit includes Bi₂O₃, Al₂O₃, SiO₂, B₂O₃, and SrO.
VIII. The electroconductive paste composition according to any one of the preceding embodiments, wherein the glass frit is substantially free of zinc oxide.
IX. The electroconductive paste composition according to any one of the preceding embodiments, wherein the glass frit has a particle size d₉₀ of about 1-3 µm, and preferably about 2-3 µm.
X. The electroconductive paste composition according to any one of the preceding embodiments, wherein the glass frit has a particle size d₁₀ of about 0.01-1 µm, preferably about 0.01-0.5 µm, and more preferably about 0.01-0.2 µm.
XI. The electroconductive paste composition according to any one of the preceding embodiments, wherein the glass frit has a particle size d₅₀ of about 0.01-3 µm, preferably about 0.01-2 µm, and more preferably about 0.1-1 µm.
XII. The electroconductive paste composition according to any one of the preceding embodiments, wherein the organic vehicle is about 20-60 wt%, preferably about 30-50 wt%, most preferably about 40-50 wt% of electroconductive paste composition, based upon 100% total weight of the paste.
XIII. The electroconductive paste composition according to any one of the preceding embodiments, wherein the organic vehicle comprises a binder, a surfactant, an organic solvent and an additional compound selected from the group consisting of surfactants, thixotropic agents, viscosity regulators, stabilizing agents, inorganic additives, thickeners, emulsifiers, dispersants, pH regulators, and any combinations thereof.
XIV. The electroconductive paste composition according to embodiment XIII, wherein the binder is at least one of poly-sugar, cellulose ester resin, phenolic resin, acrylic, polyvinyl butyral or polyester resin, polycarbonate, polyethylene or polyurethane resins, or rosin derivatives.
XV. The electroconductive paste composition according to embodiment XIII or XIV, wherein the surfactant is at least one of polyethylene oxide, polyethylene glycol, benzotriazole, poly(ethyleneglycol)acetic acid, lauric acid, oleic acid, capric acid, myristic acid, linoleic acid, stearic acid, palmitic acid, stearate salts, palmitate salts, and mixtures thereof.
XVI. The electroconductive paste composition according any one of embodiments XIII to XV, wherein the organic solvent is at least one of carbitol, terpineol, hexyl carbitol, texanol, butyl carbitol, butyl carbitol acetate, dimethyladipate or glycol ether.
XVII. The electroconductive paste composition according to any one of the preceding embodiments, further comprising about 0.01-2 wt% bismuth oxide, preferably about 1 wt% bismuth oxide, based upon 100% total weight of the paste.
XVIII. A solar cell comprising:
   a silicon wafer having a front side and a backside; and
   a soldering pad formed on the silicon wafer produced from an electroconductive paste according to any one of embodiments I to XVII.
XIX. A solar cell according to embodiment XVIII, wherein the soldering pad is formed on the backside of the solar cell.
XX. A solar cell according to any one of embodiments XVIII-XIX, wherein the soldering pad requires a pull force of at least 2.1 Newtons to be removed from the silicon wafer.
XXI. A solar cell according to any one of embodiments XVIII-XX, wherein the soldering pad requires a pull force of at least 3 Newtons to be removed from the silicon wafer.
XXII. A solar cell according to any one of embodiments XVIII-XXI, wherein the soldering pad requires a pull force of at least 4 Newtons to be removed from the silicon wafer.
XXIII. A solar cell according to any one of embodiments XVIII-XXII, wherein an electrode is formed on the front side of the silicon wafer.
XXIV. A solar cell according to any one of embodiments XVIII-XXIII, wherein the front side of the silicon wafer further comprises an antireflective layer.
XXV. A solar cell module comprising electrically interconnected solar cells according to any one of embodiments XVIII-XXIV.
XXVI. A method of producing a solar cell, comprising the steps of:
   providing a silicon wafer having a front side and a backside;
   applying an electroconductive paste composition according to any one of embodiments I-XVII onto the backside of the silicon wafer; and
   firing the silicon wafer.
XXVII. The method of producing a solar cell according to embodiment XXVI, wherein the silicon wafer has an antireflective coating on the front side.
XXVIII. The method of producing a solar cell according to embodiment XXVII or XXVIII, further comprising the step of applying an aluminum-containing paste to the backside of the silicon wafer overlapping the edges of the applied electroconductive paste composition according to embodiments I-XVII.
XXIX. The method of producing a solar cell according to any one of embodiments XXVI-XXVIII, further comprising the step of applying a silver-comprising paste to the front side of the silicon wafer.

### EXAMPLES

### Example 1

Glass compositions including about 20-30 wt% SiO₂, about 15-25 wt% Bi₂O₃, about 3-20 wt% B₂O₃, about 5-10 wt% Al₂O₃ and about 30-40 wt% SrO, based upon 100% total weight of the glass composition, were prepared. Glass samples were prepared in 100g batches by mixing individual oxide constituents in the proper ratios. The oxide mixture was loaded into a 8.34 in³ volume Colorado crucible. The crucible was then placed in an oven for 40 minutes at 600°C to preheat the oxide mixture. After preheating, the crucible was moved into a refractory oven at 1200°C for 20 minutes to melt the individual components into a glass mixture. The molten glass was then removed from the oven and poured into a bucket containing deionized water to quickly quench. This glass frit was further processed in a 1 L ceramic jar mill. The jar mill was filled approximately halfway with ½" cylindrical alumina media and deionized water. The glass frit was added to the jar mill and rolled for 8 hours at 60-80 RPM. The resulting glass frit had a particle diameter d₉₀ of about 2.3 µm. After milling, the glass frit was filtered through a 325 mesh sieve and dried at 125°C for 24 hours.

The glass composition was then mixed with spherical silver powder, silver flake, and an organic vehicle to form exemplary pastes P1-P6. As control, exemplary pastes (P4) and (P7) containing the same glass composition and organic vehicle was prepared, but the silver component was comprised only of flakes or submicron silver powder respectively. The formulations of each exemplary paste, the particle diameter d₅₀ (as set forth herein) of the various silver powders used, and the particle diameter d₅₀ of the various silver flakes used, are all set forth in Table 1 below. All amounts are based upon 100% total weight of the exemplary paste.

**Table 1. Composition of Exemplary Pastes P1-P7**

| | | **P1** | **P2** | **P3** | **P4** | **P5** | **P6** | **P7** |
|---|---|---|---|---|---|---|---|---|
| Silver | Powder, 0.5 µm | 35 | 26 | 17 | -- | -- | -- | 52 |
| | Powder, 1.0 µm | -- | -- | -- | -- | 35 | -- | -- |
| | Powder, 2.0 µm | -- | -- | -- | -- | -- | 35 | -- |
| | Flake, 5-8 µm | 17 | 26 | 35 | 52 | 17 | 17 | -- |
| Glass | | 2.1 | 2.1 | 2.1 | 2.1 | 2.1 | 2.1 | 2.1 |
| Bi₂O₃ | | 1 | 1 | 1 | 1 | 1 | 1 | 1 |
| Vehicle | | 43.9 | 43.9 | 43.9 | 43.9 | 43.9 | 43.9 | 43.9 |
| Solvent | | 1 | 1 | 1 | 1 | 1 | 1 | 1 |
| Total | | 100 | 100 | 100 | 100 | 100 | 100 | 100 |

Once the pastes were mixed to a uniform consistency, they were screen printed onto the rear side of a blank monocrystalline silicon wafer using 250 mesh stainless steel, 5 µm EOM (emulsion over mesh), at about a 30 µm wire diameter. The backside paste was printed to form soldering pads, which extend across the full length of the cell and are about 4 mm wide. Next, a different aluminum backside paste was printed all over the remaining areas of the rear side of the cell to form an aluminum BSF. The cell was then dried at an appropriate temperature. To allow for electrical performance testing, a standard front side paste was printed on the front side of the cell in a two busbar pattern. The silicon substrate, with the printed front side and backside paste, was then fired at a temperature of approximately 700-975°C.

The adhesive strength of the exemplary pastes was then measured according to the procedure previously described. As set forth above, a minimum of 1 Newton pull force (adhesive strength) is desirable. The acceptable industry standard for adhesive strength is typically above 2 Newtons. Stronger adhesion with a pull force of at least 3 Newtons, or in some instances, greater than 4 Newtons is preferred.

The adhesive performance of exemplary pastes P1-P7 is set forth in Table 2 below. All adhesive values are reported in Newtons. Paste P7, containing only silver powder, exhibited the lowest pull force of 1.5 Newton. Paste P4, containing only silver flake, also exhibited a comparably low pull force of 2.1 Newtons. Likewise, paste P3, containing a comparably high amount of silver flake (35%), exhibited a low pull force of 2.8 Newtons. Paste P1, containing a higher amount of submicron silver (35%) and a lower amount of silver flake (17%) exhibited the best adhesive performance, with a pull force of 5.4 Newtons. Pastes P2 and P5, which each contained some combination of silver powder and silver flake, also exhibited acceptable pull forces of 4.5 and 4.1 Newtons, respectively.

The pastes which exhibited the highest adhesion were those which contained a combination of silver powder and silver flake, with equal or greater amounts of silver powder than silver flake. Furthermore, as observed with Paste P1, the use of submicron silver powder (0.5 microns) exhibited the highest adhesion. Those pastes having larger silver powders and relatively higher amounts of silver flake exhibited decreased adhesion.

**Table 2. Adhesive Strength and Resistance of First Set of Exemplary Pastes P1 - P7**

| **Paste** | **P1** | **P2** | **P3** | **P4** | **P5** | **P6** | **P7** |
|---|---|---|---|---|---|---|---|
| Adhesion | 5.4 | 4.5 | 2.8 | 2.1 | 4.1 | 3.2 | 1.5 |

### Example 2

Another glass composition was prepared and rolled according to Example 1. One part glass frit batch was milled to a particle size d₉₀ of about 5-8 µm (Glass G8), another part to a particle size d₉₀ of about 3-5 µm (Glass G9), and a third part to a particle size d₉₀ of about 0.5-3 µm (Glass G10). After milling, the glass frit was filtered through a 325 mesh sieve and dried at 125°C for 24 hours.

Each of the three glass frits G8-G10 was then mixed with spherical silver powder, silver flake, and an organic vehicle using the same composition of P1 to form corresponding pastes P8-P10. Solar cells were prepared with the pastes as described in Example 1.

The electrical and adhesive performance of the resulting solar cells was then tested. The sample solar cell was analyzed using an commercial IV-tester "cetisPV-CTL1" from Halm Elektronik GmbH. All parts of the measurement equipment as well as the solar cell to be tested were maintained at 25 °C during electrical measurement. This temperature is always measured simultaneously on the cell surface during the actual measurement by a temperature probe. The Xe Arc lamp simulates the sunlight with a known AM1.5 intensity of 1000 W/m² on the cell surface. To bring the simulator to this intensity, the lamp is flashed several times within a short period of time until it reaches a stable level monitored by the "PVCTControl 4.313.0" software of the IV-tester. The Halm IV tester uses a multi-point contact method to measure current (I) and voltage (V) to determine the cell's IV-curve. To do so, the solar cell is placed between the multi-point contact probes in such a way that the probe fingers are in contact with the bus bars of the cell. The number of contact probe lines is adjusted to the number of busbars (i.e., two) on the front surface of the solar cell. All electrical values were determined directly from this curve automatically by the implemented software package. At least five wafers processed in the very same way are measured and the data interpreted by calculating the average of each value. The software PVCTControl 4.313.0 provides values for short circuit current (Isc, mA/cm²), fill factor (FF, %), efficiency (Eta, %), series resistance (mΩ) and open circuit voltage (mV).

The electrical and adhesive performance of exemplary Pastes P8-P10 is set forth in Table 3 below. As it can be seen, Paste P10, containing the glass frit having a particle size d₉₀ of about 0.5-3 µm, exhibited the best electrical performance across all parameters. The Voc, FF, and Eta of Paste P10 were higher than the same parameters for pastes P8 and P9, and the Isc and Rs were lower. Measurements of the adhesion revealed that the particle size of the glass has little to no influence on it.

**Table 3. Electrical Performance of Exemplary Solar Cells with Pastes P8-P10**

| **Paste** | **Voc (mV)** | **Isc (mA/cm²)** | **FF (%)** | **Eta (%)** | **Rs (mΩ)** | **Adhesion (N)** |
|---|---|---|---|---|---|---|
| P8 (5-8 µm) | 0.6229 | 8.489 | 77.02 | 16.732 | 1.939 | 5 |
| P9 (3-5 µm) | 0.6227 | 8.487 | 77.81 | 16.897 | 1.381 | 5 |
| P10 (1-3 µm) | 0.6236 | 8.486 | 77.89 | 16.938 | 1.255 | 5 |

## Claims

1. An electroconductive paste composition for electrode formation in solar cells comprising:
20 to 50 wt% spherical silver powder having a particle size d₅₀ of 0.1 µm to 1 µm, based upon 100% total weight of the paste, wherein particle size d₅₀ is determined by laser diffraction particle analysis;
10 to 30 wt% silver flake having a particle size d₅₀ of 5-8 µm, based upon 100% total weight of the paste;
lead-free glass frit with less than 0.5 wt% lead based upon the total weight of the glass frit and the glass frit having a particle size d₉₀ of 0.5 - 3 µm; and organic vehicle,
wherein the glass frit includes less than 5 wt% zinc oxide, based upon 100% total weight of the glass system.

2. The electroconductive paste composition according to claim 1, wherein the electroconductive paste composition comprises 20 to 40 wt% spherical silver powder, preferably 30 to 40 wt% spherical silver powder, based upon 100% total weight of the electroconductive paste composition.

3. The electroconductive paste composition according to claims 1 or 2, wherein the electroconductive paste composition comprises 10 to 20 wt% silver flake, based upon 100% total weight of the electroconductive paste composition.

4. The electroconductive paste composition according to any of the preceding claims, wherein the electroconductive paste composition comprises 30 to 75 wt% total silver, preferably 40 to 60 wt% total silver, and most preferably 50 to 60 wt% total silver, based upon 100% total weight of the paste, wherein the total silver includes the spherical silver powder and the silver flake.

5. The electroconductive paste composition according to any one of the preceding claims, wherein the spherical silver powder has a particle size d50 of 0.5 µm.

6. The electroconductive paste composition according to any one of the preceding claims, wherein the glass frit is 0.01-10 wt% of the paste, preferably 0.01-7 wt%, more preferably 0.01-6 wt%, and most preferably 0.01-5 wt%, based upon 100% total weight of the paste.

7. The electroconductive paste composition according to any one of the preceding claims, wherein the glass frit has a particle size d50 of 0.01-3 µm, preferably 0.01-2 µm, and more preferably 0.1-1 µm.

8. The electroconductive paste composition according to any one of the preceding claims, wherein the organic vehicle is 20-60 wt%, preferably 30-50 wt%, most preferably 40-50 wt% of electroconductive paste composition, based upon 100% total weight of the paste.

9. A solar cell comprising:
a silicon wafer having a front side and a backside; and
a soldering pad formed on the silicon wafer produced from an electroconductive paste according to any one of claims 1-8.

10. A solar cell according to claim 9, wherein the soldering pad is formed on the backside of the solar cell.

11. A solar cell according to any one of claims 9-10, wherein an electrode is formed on the front side of the silicon wafer.

12. A solar cell module comprising electrically interconnected solar cells according to any one of claims 9-11.

13. A method of producing a solar cell, comprising the steps of:
providing a silicon wafer having a front side and a backside;
applying an electroconductive paste composition according to any one of claims 1-8 onto the backside of the silicon wafer; and
firing the silicon wafer.

14. The method of producing a solar cell according to claim 13, wherein the silicon wafer has an antireflective coating on the front side.

15. The method of producing a solar cell according to claim 13 or 14, further comprising the step of applying an aluminum-containing paste to the backside of the silicon wafer overlapping the edges of the applied electroconductive paste composition according to claims 1-8.

16. The method of producing a solar cell according to any one of claims 13-15, further comprising the step of applying a silver-comprising paste to the front side of the silicon wafer.

## Patentansprüche

1. Elektrisch leitfähige Pastenzusammensetzung zur Elektrodenbildung in Solarzellen, umfassend:
20 bis 50 Gew.-% kugelförmiges Silberpulver mit einer Teilchengröße d₅₀ von 0,1 µm bis 1 µm, basierend auf 100 % Gesamtgewicht der Paste, wobei die Teilchengröße d50 mit Hilfe der Laserbeugungsteilchenanalyse ermittelt wird,
10 bis 30 Gew.-% Silberflocken mit einer Teilchengröße d₅₀ von 5-8 µm, basierend auf 100 % Gesamtgewicht der Paste,
bleifreie Glasurmasse mit weniger als 0,5 Gew.-% Blei basierend auf dem Gesamtgewicht der Glasurmasse, wobei die Glasurmasse eine Teilchengröße d₉₀ von 0,5-3 µm aufweist, und organischen Träger,
wobei die Glasurmasse weniger als 5 Gew.-% Zinkoxid beinhaltet, basierend auf 100 % Gesamtgewicht des Glassystems.

2. Elektrisch leitfähige Pastenzusammensetzung nach Anspruch 1, wobei die elektrisch leitfähige Pastenzusammensetzung 20 bis 40 Gew.-% kugelförmiges Silberpulver, bevorzugt 30 bis 40 Gew.-% kugelförmiges Silberpulver, basierend auf 100 % Gesamtgewicht der elektrisch leitfähigen Pastenzusammensetzung, umfasst.

3. Elektrisch leitfähige Pastenzusammensetzung nach Anspruch 1 oder 2, wobei die elektrisch leitfähige Pastenzusammensetzung 10 bis 20 Gew.-% Silberflocken, basierend auf 100 % Gesamtgewicht der elektrisch leitfähigen Pastenzusammensetzung, umfasst.

4. Elektrisch leitfähige Pastenzusammensetzung nach einem der vorherigen Ansprüche, wobei die elektrisch leitfähige Pastenzusammensetzung 30 - 50 Gew.-% Gesamtsilber, bevorzugt 40 bis 60 Gew.-% Gesamtsilber, und am bevorzugtesten 50 bis 60 Gew.-% Gesamtsilber, basierend auf 100 % Gesamtgewicht der Paste, umfasst, wobei das Gesamtsilber das kugelförmige Silberpulver und die Silberflocken beinhaltet.

5. Elektrisch leitfähige Pastenzusammensetzung nach einem der vorherigen Ansprüche, wobei das kugelförmige Silberpulver eine Teilchengröße d50 von 0,5 µm aufweist.

6. Elektrisch leitfähige Pastenzusammensetzung nach einem der vorherigen Ansprüche, wobei die Glasurmasse 0,01-10 Gew.-% der Paste, bevorzugt 0,01-7 Gew.-%, bevorzugter 0,01-6 Gew.-% und am bevorzugtesten 0,01-5 Gew.-% darstellt, basierend auf 100 % Gesamtgewicht der Paste.

7. Elektrisch leitfähige Pastenzusammensetzung nach einem der vorherigen Ansprüche, wobei die Glasurmasse eine Teilchengröße d50 von 0,01-3 µm, bevorzugt 0,01-2 µm und bevorzugter 0,01-1 µm aufweist.

8. Elektrisch leitfähige Pastenzusammensetzung nach einem der vorherigen Ansprüche, wobei der organische Träger 20-60 Gew.-%, bevorzugt 30-50 Gew.-%, am bevorzugtesten 40-50 Gew.-% der elektrisch leitfähigen Pastenzusammensetzung, basierend auf 100 % Gesamtgewicht der Paste, darstellt.

9. Solarzelle, umfassend:
einen Silizium-Wafer mit einer Vorderseite und einer Rückseite, und
eine Lötunterlage, gebildet auf dem Silizium-Wafer hergestellt aus einer elektrisch leitfähigen Paste nach einem der Ansprüche 1-8.

10. Solarzelle nach Anspruch 9, wobei die Lötunterlage auf der Rückseite der Solarzelle gebildet ist.

11. Solarzelle nach einem der Ansprüche 9-10, wobei auf der Vorderseite des Silikon-Wafers eine Elektrode gebildet ist.

12. Solarzellenmodul umfassend elektrisch miteinander verbundene Solarzellen nach einem der Ansprüche 9-11.

13. Verfahren zur Herstellung einer Solarzelle, umfassend die Schritte:
Bereitstellen eines Silikon-Wafers mit einer Vorderseite und einer Rückseite, Aufbringen einer elektrisch leitfähigen Pastenzusammensetzung nach einem der Ansprüche 1-8 auf die Rückseite des Silikon-Wafers, und
Brennen des Silikon-Wafers.

14. Verfahren zur Herstellung einer Solarzelle nach Anspruch 13, wobei der Silikon-Wafer auf der Vorderseite eine entspiegelnde Beschichtung aufweist.

15. Verfahren zur Herstellung einer Solarzelle nach Anspruch 13 oder 14, darüber hinaus umfassend den Schritt des Aufbringens einer Aluminium-haltigen Paste auf die Rückseite des Silikon-Wafers, überlappend mit den Rändern der aufgetragenen elektrisch leitfähigen Pastenzusammensetzung nach den Ansprüchen 1-8.

16. Verfahren zur Herstellung einer Solarzelle nach einem der Ansprüche 13-15, darüber hinaus umfassend den Schritt des Aufbringen einer Silberumfassenden Paste auf die Vorderseite des Silikon-Wafers.

## Revendications

1. Composition de pâte électroconductrice pour la formation d'électrode dans des piles solaires comprenant :
20 à 50 % en poids de poudre d'argent sphérique ayant une taille particulaire d₅₀ de 0,1 µm à 1 µm, basé sur 100 % de poids total de la pâte, dans laquelle la taille particulaire d₅₀ est déterminée par analyse particulaire à diffraction laser ;
10 à 30 % en poids de paillette d'argent ayant une taille particulaire d₅₀ de 5 à 8 µm, basés sur 100 % de poids total de la pâte ;
de la fritte de verre exempte de plomb avec moins de 0,5 % en poids de plomb, basé sur le poids total de la fritte de verre et la fritte de verre ayant une taille particulaire d₉₀ de 0,5 à 3 µm ; et un excipient organique,
dans laquelle la fritte de verre inclut moins de 5 % en poids d'oxyde de zinc, basés sur 100 % de poids total du système de verre.

2. Composition de pâte électroconductrice selon la revendication 1, dans laquelle la composition de pâte électroconductrice comprend 20 à 40 % en poids de poudre d'argent sphérique, de préférence 30 à 40 % en poids de poudre d'argent sphérique, basés sur 100 % de poids total de la composition de pâte électroconductrice.

3. Composition de pâte électroconductrice selon la revendication 1 ou 2, dans laquelle la composition de pâte électroconductrice comprend 10 à 20 % en poids de paillette d'argent, basés sur 100 % de poids total de la composition de pâte électroconductrice.

4. Composition de pâte électroconductrice selon l'une quelconque des revendications précédentes, dans laquelle la composition de pâte électroconductrice comprend 30 à 75 % en poids d'argent total, de préférence 40 à 60 % en poids d'argent total et de manière préférée entre toutes 50 à 60 % en poids d'argent total, basés sur 100 % de poids total de la pâte, dans laquelle l'argent total inclut la poudre d'argent sphérique et la paillette d'argent.

5. Composition de pâte électroconductrice selon l'une quelconque des revendications précédentes, dans laquelle la poudre d'argent sphérique a une taille particulaire d50 de 0,5 µm.

6. Composition de pâte électroconductrice selon l'une quelconque des revendications précédentes, dans laquelle la fritte de verre est 0,01 à 10 % en poids de la pâte, de préférence 0,01 à 7 % en poids, plus préférablement 0,01 à 6 % en poids et de manière préférée entre toutes 0,01 à 5 % en poids, basés sur 100 % de poids total de la pâte.

7. Composition de pâte électroconductrice selon l'une quelconque des revendications précédentes, dans laquelle la fritte de verre a une taille particulaire d50 de 0,01 à 3 µm, de préférence 0,01 à 2 µm et plus préférablement 0,1 à 1 µm.

8. Composition de pâte électroconductrice selon l'une quelconque des revendications précédentes, dans laquelle l'excipient organique est 20 à 60 % en poids, de préférence 30 à 50 % en poids, plus préférablement 40 à 50 % en poids de la composition de pâte électroconductrice, basés sur 100 % de poids total de la pâte.

9. Pile solaire comprenant :
une tranche de silicium ayant un côté avant et un côté arrière ; et
un plot à souder formé sur la tranche de silicium produit à partir d'une pâte électroconductrice selon l'une quelconque des revendications 1 à 8.

10. Pile solaire selon la revendication 9, dans laquelle le plot à souder est formé sur le côté arrière de la pile solaire.

11. Pile solaire selon l'une quelconque des revendications 9 et 10, dans laquelle une électrode est formée sur le côté avant de la tranche de silicium.

12. Module de piles solaires comprenant des piles solaires interconnectées électriquement selon l'une quelconque des revendications 9 à 11.

13. Procédé de production d'une pile solaire comprenant les étapes consistant à :
fournir une tranche de silicium ayant un côté avant et un côté arrière ;
appliquer une composition de pâte électroconductrice selon l'une quelconque des revendications 1 à 8 sur le côté arrière de la tranche de silicium ; et
cuire la tranche de silicium.

14. Procédé de production d'une pile solaire selon la revendication 13, dans lequel la tranche de silicium a un revêtement antiréflecteur sur le côté avant.

15. Procédé de production d'une pile solaire selon la revendication 13 ou 14, comprenant en outre l'étape consistant à appliquer une pâte contenant de l'aluminium au côté arrière de la tranche de silicium chevauchant les bords de la composition de pâte électroconductrice appliquée selon les revendications 1 à 8.

16. Procédé de production d'une pile solaire selon l'une quelconque des revendications 13 à 15, comprenant en outre l'étape consistant à appliquer une pâte comprenant de l'argent au côté avant de la tranche de silicium.
